# EUROPEAN PATENT APPLICATION

(11) **EP 1 686 594 A1**
(43) Date of publication of application: **02.08.2006**
(21) Application number: 04793017.7
(22) Date of filing: 27.10.2004
(51) Int. Cl.: H01B 12/04, H01B 12/10, H01B 13/00

(54) **SUPERCONDUCTIVE WIRE MATERIAL, SUPERCONDUCTIVE MULTI-CONDUCTOR WIRE USING THE SAME AND METHOD FOR PRODUCING THE SAME**

(30) Priority: 21.11.2003 JP 2003392406
(71) Applicant: Sumitomo Electric Industries, Ltd., Osaka-shi, Osaka 541-0041 (JP)
(72) Inventor: UEYAMA, Munetsugu, c/o Osaka Works of, Konohana-ku, Osaka-shi, Osaka 5548511 (JP); FUJIKAMI, Jun, c/o Osaka Works of, Konohana-ku, Osaka-shi, Osaka 5548511 (JP)
(74) Representative: Kreutzer, Ulrich
(86) International application number: PCT/JP2004/015905
(87) International publication number: WO 2005/050674

(57) **Abstract**

There is provided a superconducting wire that has a high critical current density and is less likely to suffer longitudinal cracking and breakage during the steps of manufacturing the same. The superconducting wire according to the present invention is an oxide superconducting wire including an oxide superconductor and a cladding metal for cladding the oxide superconductor, and is **characterized in that** a material of the cladding metal has a breaking strain of at least 30% in a stress-strain test.

## Description

### Technical Field

The present invention relates to a superconducting wire. More particularly, the present invention relates to a superconducting wire including an oxide superconductor and a cladding metal. The present invention also relates to a superconducting multifilamentary wire including a plurality of the superconducting wires and a second cladding metal.

Furthermore, the present invention relates to a method of manufacturing the superconducting wire. The present invention also relates to a method of manufacturing the superconducting multifilamentary wire.

### Background Art

A bismuth-based multifilamentary wire has conventionally been developed as an oxide high-temperature superconducting wire. For a method of manufacturing a bismuth-based multifilamentary wire, there has been known a technique of forming an oxide superconductor having a (BiPb)₂Sr₂Ca₂Cu₃Oₓ phase (a Bi-2223 phase), for example, into a long, tape-like wire by a powder-in-tube method. In this method, a metal pipe is initially filled with a raw powder of a superconducting phase, for example, and then drawn into a clad wire. A plurality of the clad wires are inserted into a metal pipe again and drawn into a multifilamentary wire. The multifilamentary wire is rolled into a tape wire in which a metal sheath accommodates multiple of superconducting filaments.

In this method, the tape wire is further subjected to primary heat treatment for producing a target superconducting phase. The tape wire is then rolled again to undergo secondary heat treatment so that crystal grains in the superconducting phase are bonded together. Although plastic working and heat treatment are conducted twice, each of them may be conducted only once.

Since a bismuth-based oxide superconductor having a Bi-2223 phase as the most familiar example, is ceramics, and tends to be brittle and less flexible, it is generally clad with a cladding metal. However, a certain type of metal used for a metal sheath is known to have an adverse effect on superconducting performance of a bismuth-based oxide superconductor. Therefore, silver, which is known to have no adverse effect thereon, is often used for the metal sheath.

When a comparison is made to superconducting wires identical in cross-sectional area and in critical current density of an oxide superconductor, a wire having a larger proportion of an oxide superconducting phase exhibits a larger critical current value. Therefore, from the viewpoint of a critical current property, it is preferable to manufacture a superconducting wire having the largest possible proportion of an oxide superconductor. However, when such a superconducting wire is manufactured, a brittle portion of lower strength is increased, which tends to cause longitudinal cracking and breakage thereof during processing. If a portion of the superconducting wire cracked longitudinally continues to be processed, the inside of the portion tends to suffer irregularities, which lowers a critical current density significantly. Therefore, it becomes difficult to manufacture a superconducting wire with a favorable property.

In order to be able to manufacture a superconducting wire with a favorable property, many techniques relating to a method of manufacturing the same have been developed. For example, there is disclosed a method of manufacturing a superconducting wire including the steps of filling a metal pipe with a raw powder of a superconducting phase and subjecting the metal pipe to plastic working at least once and heat treatment at least once to obtain a wire, and conducting low-oxygen heat treatment such that the wire is heated at a temperature lower than the temperature of the heat treatment above in an oxygen-reduced atmosphere compared to the air (see Patent Document 1). This method can be used to improve a critical current of the superconducting wire than the known conventional method.

However, when a superconducting wire having a large proportion of an oxide superconductor is manufactured, a brittle portion of lower strength is increased. Therefore, it is difficult even for this method to suppress the tendency of longitudinal cracking and breakage to occur during processing.

There is also disclosed a method of manufacturing a superconducting wire including the steps of filling a metal pipe with a raw powder of a superconducting phase, drawing the metal pipe into a clad wire, binding a plurality of the clad wires to insert the same into a metal pipe again such that the clad wires are placed to take a polygonal shape and drawing the metal pipe into a multifilamentary wire, rolling the multifilamentary wire into a tape wire in which a metal sheath accommodates multiple of superconducting filaments. In the method, the multifilamentary wire is rolled by being pressed in a diagonal direction or in a direction from one side to the opposite side, with respect to the polygonal shape taken by the clad wires (see Patent Document 2).

However, when a superconducting wire having a large proportion of an oxide superconductor is manufactured, a brittle portion of lower strength is increased. Therefore, it is difficult even for this method to suppress the tendency of longitudinal cracking and breakage to occur during processing.
Patent Document 1: Japanese Patent Laying-Open No. 2003-203532
Patent Document 2: Japanese Patent Laying-Open No. 2003-242847

### Disclosure of the Invention

### Problems to be Solved by the Invention

As described above, when a superconducting wire having a large proportion of an oxide superconductor is manufactured, a brittle portion of lower strength is increased. Therefore, there has not yet been completely solved the problem of longitudinal cracking and breakage thereof caused during processing.

Therefore, an object of the present invention is to provide a superconducting wire whose critical current density is high due to a large proportion of an oxide superconductor and which is less likely to suffer longitudinal cracking and breakage during a step of manufacturing the same.

Another object of the present invention is to provide a superconducting multifilamentary wire whose critical current density is high due to a large proportion of an oxide superconductor and which is less likely to suffer longitudinal cracking and breakage during a step of manufacturing the same.

Still another object of the present invention is to provide a method of manufacturing a superconducting wire that can manufacture, without causing longitudinal cracking and breakage, a superconducting wire excellent in critical current density due to a large proportion of an oxide superconductor.

A further object of the present invention is to provide a method of manufacturing a superconducting multifilamentary wire that can manufacture, without causing longitudinal cracking and breakage, a superconducting multifilamentary wire excellent in critical current density due to a large proportion of an oxide superconductor.

### Means for Solving the Problems

The present inventors conceived an idea that a study of the mechanical property of a cladding metal such as a silver pipe, which had not been paid attention to, would be useful to solve the problems above, and thus prototyped superconducting wires and superconducting multifilamentary wires containing various materials and having various structures, for example, to determine which materials and which conditions of the cladding metal make it possible to manufacture, without causing longitudinal cracking and breakage, a superconducting multiwire and a superconducting multifilamentary wire excellent in critical current density due to a large proportion of an oxide superconductor.

According to the findings, the present inventors have found that such longitudinal cracking and breakage occur because a larger proportion of an oxide superconductor actually lowers a proportion of a cladding metal material that serves as a structural material of a superconducting wire and a superconducting multifilamentary wire, resulting in that the structural material can no longer endure stress and strain caused during processing.

The present inventors have also found that, by adjusting a breaking strain of the cladding metal material in a stress-strain test to fall within a certain range, it is possible to manufacture a superconducting multiwire and a superconducting multifilamentary wire excellent in critical current density due to a large proportion of an oxide superconductor without causing longitudinal cracking and breakage. Accordingly, the present inventor has overcome the problems above and achieved the present invention.

Specifically, the present invention is an oxide superconducting wire including an oxide superconductor and a cladding metal for cladding the oxide superconductor, in which a material of the cladding metal has a breaking strain of at least 30% in a stress-strain test.

The breaking strain preferably falls within a range of 30% to 58%, more preferably a range of 45% to 58%. The proportion of the oxide superconductor preferably falls within a range of 25% to 70%. The material of the cladding metal preferably has a maximum stress of at least 180 MPa in a stress-strain test.

The material of the cladding metal preferably contains silver and/or silver alloy. Furthermore, the material of the oxide superconductor preferably contains a bismuth-based oxide superconductor. For the material of the cladding metal, it is particularly preferable to use silver having an impurity concentration of 10 ppm to 500 ppm. The impurity concentration is also an indicator of a processing crack. Therefore, by controlling an impurity concentraion of the cladding metal, processing cracks can further be decreased in frequency.

A superconducting multifilamentary wire according to the present invention is a superconducting multifilamentary wire including a plurality of the superconducting wires and a second cladding metal for cladding the superconducting wires. The superconducting multifilamentary wire preferably has a tape-like shape.

A method of manufacturing a superconducting wire according to the present invention includes the steps of filling a metal cylinder made of a material of a cladding metal material having a breaking strain falling within a range of 30% to 58% in a stress-strain test, with a raw powder containing a raw material of an oxide superconductor, and subjecting the metal cylinder filled with the raw powder to plastic working at least once and heat treatment at least once. In order to reduce processing cracks, silver having an impurity concentration of 10 ppm to 500 ppm is preferable for the material of the cladding metal used for manufacturing the superconducting wire.

A method of manufacturing a superconducting multifilamentary wire according to the present invention includes the steps of filling a metal cylinder made of a material of a cladding metal having a breaking strain falling within a range of 30% to 58% in a stress-strain test, with a raw powder containing a raw material of an oxide superconductor, subjecting the metal cylinder filled with the raw powder to plastic working at least once to obtain a wire, filling a metal cylinder that is to serve as a material of a second cladding metal with a plurality of the wires, and subjecting the metal cylinder filled with the plurality of the wires to plastic working at least once and heat treatment at least once to obtain a superconducting multifilamentary wire. In this method, silver having an impurity concentration of 10 ppm to 500 ppm is also preferable for the material of the cladding metal.

### Effects of the Invention

As described below, the superconducting wire according to the present invention is excellent in critical current density and workability because it has a high critical current density due to a large proportion of an oxide superconductor and is less likely to suffer longitudinal cracking and breakage during a step of manufacturing the same due to a breaking strain of the material of the cladding metal that falls within a certain range in a stress-strain test.

The superconducting multifilamentary wire according to the present invention is excellent in critical current density and workability because it has a high critical current density due to a large proportion of an oxide superconductor and is less likely to suffer longitudinal cracking and breakage during a step of manufacturing the same due to a breaking strain of the cladding metal material that falls within a certain range in a stress-strain test. Furthermore, the method of manufacturing a superconducting wire according to the present invention makes it possible to manufacture, without causing longitudinal cracking and breakage, a superconducting wire excellent in critical current density due to a large proportion of an oxide superconductor.

The method of manufacturing a superconducting multifilamentary wire according to the present invention makes it possible to manufacture, without causing longitudinal cracking and breakage, a superconducting multifilamentary wire excellent in critical current density due to a large proportion of an oxide superconductor.

### Brief Description of the Drawings

Fig. 1 is a flowchart showing an example of a method of manufacturing a superconducting wire according to the present invention.
Fig. 2 is a flowchart showing an example of a method of manufacturing a superconducting multifilamentary wire according to the present invention.
Fig. 3 is a photographic diagram showing how a stress-strain test is conducted on a silver and/or silver alloy pipe used in examples and comparative examples of the present invention.

### Best Modes for Carrying Out the Invention

The present invention will now be described in more detail with reference to embodiments thereof.

### (Definition)

In the present application, a superconducting wire means a wire having a superconducting phase and a cladding material for cladding the superconducting phase. A single superconducting wire may include a single superconducting phase or a plurality of superconducting phases.

In the present application, a superconducting multifilamentary wire means a wire having a plurality of superconducting phases and a cladding material for cladding the superconducting phases. The cladding material may be a single layer or a multilayer.

In the present application, a superconducting wire is intended to embrace a broader concept including a superconducting multifilamentary wire. According to the definition above, a superconducting multifilamentary wire may include a plurality of superconducting wires, and this superconducting multifilamentary wire is also considered as a superconducting wire.

### (Method of Manufacturing Superconducting Wire and Superconducting Multifilamentary Wire)

Conventionally, a method of manufacturing a superconducting wire preferably includes the steps of preparing a raw powder of an oxide superconductor, filling a metal pipe with the raw powder, conducting plastic working on the metal pipe filled with the raw powder, and conducting heat treatment on the metal pipe filled with the raw powder and subjected to plastic working.

More specifically, when the above method of manufacturing a superconducting wire is a method of manufacturing a superconducting multifilamentary wire, the step of conducting plastic working preferably includes the steps of manufacturing a clad wire, manufacturing a multifilamentary wire, and rolling the multifilamentary wire to manufacture a tape wire. Each of the steps of conducting plastic working and conducting heat treatment may be performed twice or more times.

When the above method of manufacturing a superconducting wire is a method of manufacturing a bismuth-based multifilamentary wire, an oxide superconductor having a (BiPb)₂Sr₂Ca₂Cu₃Oₓ phase (a Bi-2223 phase), for example, is preferably formed into a long, tape-like wire by the powder-in-tube method.

In this method, for example, a metal pipe is initially filled with a raw powder of a superconducting phase and then drawn into a clad wire. A plurality of the clad wires are bound and inserted into a metal pipe again to be drawn into a multifilamentary wire. The multifilamentary wire is then rolled into a tape wire in which a metal sheath accommodates multiple of superconducting filaments.

In this method, the tape wire is further subjected to primary heat treatment to produce a target superconducting phase. The tape wire is then rolled again and subjected to secondary heat treatment so that crystal grains in the superconducting phase are bonded together. Although plastic working and heat treatment are conducted twice, each of them may be conducted only once.

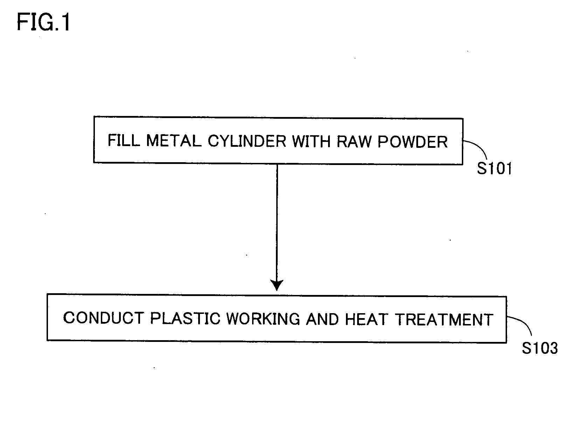

Fig. 1 is a flowchart showing an example of the method of manufacturing a superconducting wire according to the present invention. In this method, it is also possible to use a method similar to the above-described, conventional method of manufacturing a superconducting wire. As shown in Fig. 1, however, it is particularly preferable to use a method of manufacturing a superconducting wire including the steps of filling a metal cylinder which is to serve as a cladding metal material and which contains a material whose breaking strain in a stress-strain test falls within a certain range, with a raw powder containing a material of an oxide superconductor (S101), and subjecting the metal cylinder filled with the raw powder to plastic working at least once and heat treatment at least once (S103).

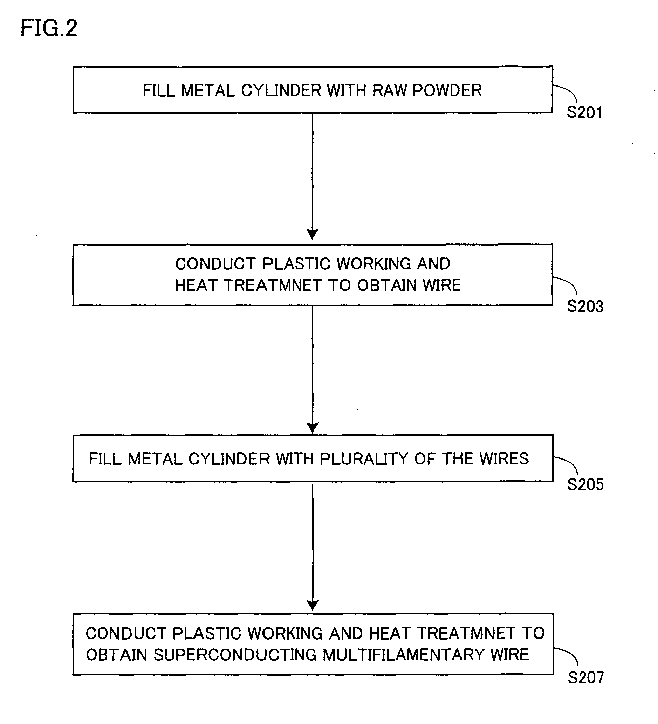

Fig. 2 is a flowchart showing an example of the method of manufacturing a superconducting multifilamentary wire according to the present invention. In this method, it is also possible to use a method similar to the above-described, conventional method of manufacturing a superconducting multifilamentary wire. As shown in Fig. 2, however, it is particularly preferable to use a method of manufacturing a superconducting multifilamentary wire including the steps of filling a metal cylinder which is to serve as a cladding metal material and which contains a material whose breaking strain in a stress-strain test falls within a certain range, with a raw powder containing a material of an oxide superconductor (S201), subjecting the metal cylinder filled with the raw powder to plastic working at least once to obtain a wire (S203), filling a metal cylinder which is to serve as a second cladding metal material, with a plurality of the wires (S205), and subjecting the metal cylinder filled with the plurality of the wires to plastic working at least once and heat treatment at least once to obtain a superconducting multifilamentary wire (S207).

### (Raw Powder)

For the raw powder of an oxide superconductor used in the present invention, it is suitable to use a raw powder formulated to be able to obtain a superconducting phase that can finally have a critical temperature of at least 77K. The raw powder contains not only a powder in which complex oxides are blended in a given composition ratio, but a powder made by sintering the blended powder above and milled.

When a material finally containing a bismuth-based (e.g. Bi2223-based) oxide superconductor is used for the material of an oxide superconductor according to the present invention, a blended raw powder containing powders of Bi₂O₃, PbO, SrCO₃, CaCO₃, and CuO is preferably used as a starting raw powder. The blended raw powder is subjected to heat treatment at least once at 700 to 800°C for 10 to 40 hours in an atmosphere at an atmospheric pressure or in a decompressed atmosphere so that there can be obtained a raw powder mainly composed of a Bi2212 phase rather than a Bi2223 phase, which can be suitably used as a raw powder of the oxide superconductor in the present invention.

The starting raw powder preferably has a specific composition rate that satisfies a relation (a+b):c:d:e = 1.7 to 2.8:1.7 to 2.5:1.7 to 2.8:3 in BiₐPb_{b}Sr_{c}Ca_{d}Cuₑ. In particular, a composition ratio mainly satisfying a relation (Bi or (Bi+Pb)):Sr:Ca:Cu = 2:2:2:3 is suitable. A relation Bi:Pb:Sr:Ca:Cu = approximately 1.8:0.3 to 0.4:approximately 2:approximately 2.2:approximately 3.0 is particularly preferable.

A raw powder to fill the metal cylinder used in the present invention preferably has a maximum grain size of at most 2.0 µm and an average grain size of at most 1.0 µm because the use of such a fine powder makes it easy to produce a high-temperature oxide superconductor.

### (Metal Cylinder)

For the material of the metal cylinder (metal pipe) used in the present invention, it is preferable to use at least one type of metal selected from the group consisting of Ag, Cu, Fe, Ni, Cr, Ti, Mo, W, Pt, Pd, Rh, Ir, Ru, and Os and/or alloy based on the at least one type of metal. From the viewpoint of reactivity to an oxide superconductor and workability, it is particularly preferable to use silver and/or silver alloy.

For the material of the metal cylinder that is to serve as a material of cladding metal used in manufacturing a superconducting wire according to the present invention, the use of a material whose breaking strain is sufficiently large can suppress longitudinal cracking and breakage caused during processing such as rolling. This is because a material having a large breaking strain has excellent elongation, and a material superior in elongation is thought to have higher ductility and is less likely to suffer longitudinal cracking and breakage.

The material of the metal cylinder used in the present invention preferably has a breaking strain of at least 30%, more preferably at least 45%, in a stress-strain test. Silver/ silver alloy preferably has a breaking strain of at most 58%.

From the viewpoint of workability, a larger breaking strain is preferable. However, it tends to lower a maximum stress value. Therefore, a breaking strain preferably falls within the ranges above in order to achieve workability as well as performance of a superconductor. When silver and/or silver alloy is used for the material of the metal cylinder, it has a breaking strain of approximately 58% at a maximum stress of 180 MPa as described below. Therefore, the maximum breaking strain thereof is preferably limited to at most 58%.

In addition to a higher breaking strain, a larger maximum stress in a strain-stress test is more useful because it makes an oxide superconductor more compact and makes an internal cross sectional shape more uniform. When a cladding material has a larger maximum stress (particularly a proof stress of 0.2%), larger force can be applied to an oxide superconductor as well as the cladding material during subsequent processing. This is because the maximum force to be applied to an oxide superconductor during processing is determined by the maximum stress of a material of the cladding metal. From the viewpoint of making an oxide superconductor more compact and making an internal cross sectional shape more uniform, it is advantageous to apply larger force.

Therefore, the material of the metal cylinder used in the present invention preferably has a maximum stress of at least 180 MPa in a stress-strain test because a larger maximum stress (a maximum stress value) enables a larger force to be applied to an oxide superconductor during processing of a superconducting wire and a superconducting multifilamentary wire, which can make the oxide superconductor more compact and make its internal cross sectional shape more uniform. Furthermore, since a metal cylinder made of silver and/or silver alloy has a maximum stress of approximately 180 MPa, the use of a metal cylinder whose maximum stress is actually at least 180 MPa can provide a favorable superconducting wire and superconducting multifilamentary wire.

In typical metal and/or alloy, a higher breaking strain tends to lower a maximum stress. However, in order to obtain a compact and uniform oxide superconductor, a higher maximum stress (particularly a proof stress of 0.2%) is advantageous. Therefore, it is preferable to use a hard and ductile material for the material of the metal cylinder used in the present invention.

For the material of the metal cylinder used in the present invention, the use of the material having the properties above is more effective when a proportion of an oxide superconductor to a superconducting wire and a superconducting multifilamentary wire is at least 30%.

This is because the material having the properties above has high elongation and is less likely to suffer longitudinal cracking and breakage during processing. If a proportion of an oxide superconductor to a superconducting wire and a superconducting multifilamentary wire is decreased, a proportion of a cladding metal is increased. In this case, although the material of a metal cylinder has lower elongation, its larger volume enables a superconducting wire and a superconducting multifilamentary wire to be processed without any problem. However, if a proportion of an oxide superconductor is equal to or above 30%, a problem of a processing crack becomes significant. Therefore, it is more necessary to use a material of the metal cylinder having high elongation.

### (Plastic Working)

The plastic working in the method of manufacturing a superconducting wire and a superconducting multifilamentary wire according to the present invention includes various types of area reduction working. More specifically, examples of area reduction working include wire drawing, rolling, pressing, swaging and the like.

If plastic working is conducted only once in the method of manufacturing a superconducting multifilamentary wire according to the present invention, it preferably includes the practical steps of conducting area reduction on a metal cylinder filled with a raw powder to form a clad wire, conducting area reduction on a metal cylinder into which the bound clad wires are inserted to form a multifilamentary wire, and processing the multifilamentary wire into a tape-like shape.

The multifilamentary wire is processed into a tape-like shape in order that crystals finally formed in a superconducting multifilamentary wire are oriented in one direction. Generally, a density of current that can flow through an oxide-based superconducting multifilamentary wire varies enormously, depending on an orientation of the crystals. Therefore, a higher current density can be obtained by orienting the crystals in one direction.

### (Heat Treatment)

The heat treatment in the method of manufacturing a superconducting wire and a superconducting multifilamentary wire according to the present invention is preferably conducted twice or more times, and typically, primary and secondary heat treatments are conducted. The primary heat treatment is mainly intended to produce an oxide superconductor such as a Bi2223 phase. The secondary heat treatment is mainly intended to firmly bind the crystals of an oxide superconductor such as a Bi2223 phase relative to each other.

Both of the primary and secondary heat treatments in the method of manufacturing a superconducting wire and a superconducting multifilamentary wire according to the present invention are preferably conducted at least 815C°, particularly at least 830C°. In addition, they are preferably conducted at most 860C°, particularly at most 850C°.

In particular, it is very suitable for the primary heat treatment to be conducted at a temperature in a range of 840C° to 850C°, and the secondary heat treatment to be conducted at a temperature in a range of 830C° to 840C°. Moreover, the secondary heat treatment may be conducted in a plurality of stages (particularly 2 stages) at different temperatures falling within the range above.

Each of the primary and secondary heat treatments in the method of manufacturing a superconducting wire and a superconducting multifilamentary wire according to the present invention is preferably conducted for at least 50 hours and for at most 250 hours. In particular, it is very suitable for the secondary heat treatment to be conducted for at least 100 hours.

Both of the primary and secondary heat treatments in the method of manufacturing a superconducting wire and a superconducting multifilamentary wire according to the present invention may be conducted in an air atmosphere. Furthermore, it is more preferable for the heat treatments to be conducted in an airflow having the same components as those of the atmospheric air. In doing so, it is preferable to reduce a moisture content in the atmosphere used for the heat treatments.

### (Superconducting Wire)

The superconducting wire according to the present invention is an oxide superconducting wire including an oxide superconductor and a cladding metal for cladding the oxide superconductor, in which a material of the cladding metal has a breaking strain that falls within a certain range in a stress-strain test.

The breaking strain above is preferably at least 30%, particularly at least 45%. In addition, the breaking strain is preferably at most 58%. The reason thereof is the same as above in the description of the method of manufacturing a superconducting wire according to the present invention.

The material of the cladding metal used in the present invention preferably has a maximum stress of at least 180 MPa in a stress-strain test. The reason thereof is the same as above in the description of the method of manufacturing a superconducting wire according to the present invention.

It is more effective to use a material having the properties above for the cladding metal used in the present invention when a proportion of an oxide superconductor to the superconducting wire according to the present invention is at least 30%. More specifically, a proportion of an oxide superconductor to the superconducting wire and the superconducting multifilamentary wire, in which it is suitable to use a material having the properties above, is preferably at least 30%. The reason thereof is the same as above in the description of the method of manufacturing a superconducting wire according to the present invention.

For the material of the cladding metal used in the present invention, it is preferable to use at least one type of metal selected from the group consisting of Ag, Cu, Fe, Ni, Cr, Ti, Mo, W, Pt, Pd, Rh, Ir, Ru, and Os and/or alloy based on the at least one type of metal. From the viewpoint of workability and reactivity to an oxide superconductor, it is particularly preferable to use silver and/or silver alloy. The reason thereof is the same as above in the description of the method of manufacturing a superconducting wire according to the present invention.

The material of an oxide superconductor used in the present invention preferably contains a bismuth-based oxide superconductor. For example, as described in the method of manufacturing a superconducting wire according to the present invention, the material preferably contains a bismuth-based oxide superconductor obtained, for example, from a blended raw powder containing powders of Bi₂O₃, PbO, SrCO₃, CaCO₃, and CuO. This is because, when a superconducting wire is manufactured by a suitable method such as the method of manufacturing a superconducting wire according to the present invention, it is possible to obtain a superconducting phase that can finally have a high critical temperature of at least 77K.

### (Superconducting Multifilamentary Wire)

The superconducting multifilamentary wire according to the present invention is a superconducting multifilamentary wire having a plurality of the superconducting wires above, and a second cladding metal for cladding the superconducting wires. The superconducting multifilamentary wire according to the present invention preferably has a tape-like shape. The reason thereof is the same as above in the description of the method of manufacturing a superconducting multifilamentary wire according to the present invention.

Properties of the cladding metal and the oxide superconductor used for the superconducting multifilamentary wire according to the present invention are preferably similar to those of the cladding metal and the oxide superconductor used for the superconducting wire according to the present invention. The reason thereof is the same as above in the description of the method of manufacturing a superconducting wire according to the present invention.

The present invention will now be described in more detail with reference to examples. However, the present invention is not limited thereto.

### (First Embodiment)

Powders of Bi₂O₃, PbO, SrCO₃, CaCO₃, and CuO were blended in the ratios 1.8:0.3:1.9:2.0:3.0 to form a blended powder, which was then successively subjected to heat treatments at 700C° for 8 hours, at 800C° for 10 hours, and at 840C° for 8 hours, respectively, in an atmospheric air. The blended powder was milled after each of the heat treatments to produce a raw powder.

A silver pipe having an outside diameter of 36 mm, an inside diameter of 33.5 mm, a length of 1000 mm, an oxide content of 50 ppm, a carbon content of 20 ppm, and a silver purity of 4N was filled with the raw powder above to be drawn into a clad wire having a diameter of 3.7 mm. Fifty-five clad wires were bound to take a hexagonal shape and inserted into a silver alloy pipe having an outside diameter of 36 mm, an inside diameter of 28 mm, and a length of 1000 mm, to be drawn into a multifilamentary wire having a diameter of 1.6 mm. Furthermore, the multifilamentary wire was rolled (primarily rolled) to form a tape-like multifilamentary wire.

The tape-like mulicore wire obtained was subjected to primary heat treatment in an air atmosphere at 840C° to 850 C° for 50 hours. The tape-like multifilamentary wire after the primary heat treatment was then rolled again (secondarily rolled) into a tape-like multifilamentary wire having a width of 4.0 mm and a thickness of 0.2 mm, which was then subjected to a secondary heat treatment in an air atmosphere at 840C° to 850 C° for 50 hours to 150 hours to obtain a superconducting multifilamentary wire. The number of cracks caused by drawing during the steps of manufacturing the superconducting multifilamentary wire was checked by visual inspection, the results of which is shown in Table 1.

**[Table 1]**

| | cladding metal | | | oxide superconductor | | number of cracks caused by drawing |
|---|---|---|---|---|---|---|
| | type | breaking strain (%) | maximum stress (MPa) | type | proportion (%) | |
| Comparative Example 1 | silver alloy | 7.6 | 273 | Bi2223 | 33 | 15 |
| Comparative Example 2 | silver alloy | 12.1 | 279 | Bi2223 | 36 | 2 |
| Comparative Example 3 | silver alloy | 13.3 | 257 | Bi2223 | 33 | 5 |
| Comparative Example 4 | silver alloy | 21.7 | 243 | Bi2223 | 42 | 5 |
| Comparative Example 5 | silver alloy | 26.3 | 232 | Bi2223 | 43 | 2 |
| Example 1 | silver alloy | 45.6 | 191 | Bi2223 | 43 | 0 |
| Example 2 | silver alloy | 45.8 | 188 | Bi2223 | 33 | 0 |
| Example 3 | silver alloy | 49.0 | 185 | Bi2223 | 42 | 0 |
| Example 4 | silver alloy | 50.8 | 184 | Bi2223 | 33 | 0 |
| Example 5 | silver alloy | 58.8 | 178 | Bi2223 | 40 | 0 |

### (Examples 2 to 5 and Comparative Examples 1 to 5)

In Examples 2 to 5 and Comparative Examples 1 to 5, superconducting multifilamentary wires were obtained as in Example 1 by using cladding metals having the properties shown in Table 1, except that the proportions of oxide superconductors were as shown in Table 1.

### (Method of Stress-Strain Test on Silver and/or Silver Alloy Pipe)

The silver and/or silver alloy pipes used in Examples 1 to 5 and Comparative Examples 1 to 5 were subjected to a stress-strain test by using a tension test machine at a testing rate of 3mm/min, with a distance between holders being 110 mm, to obtain strains at break (%) and maximum stresses (MPa) of the silver and/or silver alloy pipes, respectively. The results thereof are shown in Table 1.

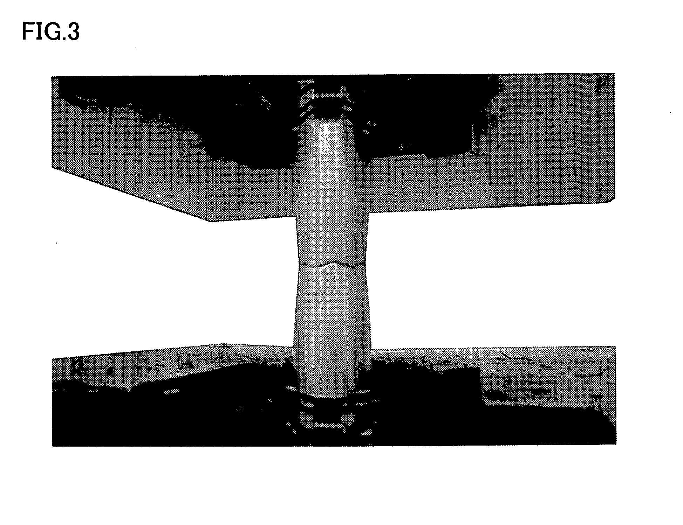

Fig. 3 is a photographic diagram showing how the stress-strain test is conducted on a silver/ silver alloy pipe used in the examples and comparative examples in the present invention.

As shown in the results above, superconducting multifilamentary wires of Comparative Examples 1 to 5, which used the silver and/or silver alloy pipes having strains at break of less than 30%, suffered many cracks caused by drawing during the steps of manufacturing the same. On the contrary, superconducting multifilamentary wires of Examples 1 to 5, which used the silver and/or silver alloy pipes having strains at break of at least 30%, suffered no crack caused by drawing during the steps of manufacturing the same.

Therefore, the superconducting multifilamentary wires in Examples 1 to 5 are found to be superior to those in Comparative Examples 1 to 5 because the materials of the cladding metals have higher strains at break, which causes less cracks due to drawing during the steps of manufacturing the same.

### (Examples 6 to 10)

Example 1 used a silver pipe having a silver purity of 4N (99.99%). An impurity concentration of the silver pipe having a silver purity of 4N corresponds to 100 ppm. In Examples 6 to 10, superconducting multifilamentary wires were manufactured as in Example 1, except that there were used silver pipes having impurity concentrations of 5 ppm (Example 6), 10 ppm (Example 7), 50 ppm (Example 8), 500 ppm (Example 9), and 1000 ppm (Exmaple 10), respectively, to examine the correlation between an impurity concentration of a cladding metal and a processing crack. Examples of impurities were Al, Fe, Cu, Ni, Si, Zn and others.

When cracks caused by drawing during the steps of manufacturing were checked by visual inspection, it was found that cracks occurred at an impurity concentrations of 5 ppm (Example 6) and 1000 ppm (Example 10). Considering these results along with the result in Example 1 whose silver pipe had an impurity concentration of 100 ppm, it is found that an impurity concentration is also an indicator of processing cracks, and thus a frequency of the occurrence of processing cracks can be reduced by controlling an impurity concentration, and that silver having an impurity concentration of 10 ppm to 500 ppm is preferably used for the cladding metal.

It should be understood that the embodiments and examples disclosed here are illustrative in all respects and are not to be taken by way of limitation. The scope of the present invention is not limited by the description above, but by the terms of the appended claims, and all the modifications made within the scope of the claims and the equivalents thereof are intended to be embraced.

## Claims

1. A superconducting wire, comprising an oxide superconductor and a cladding metal for cladding said oxide superconductor, a material of said cladding metal having a breaking strain of at least 30% in a stress-strain test.

2. The superconducting wire according to claim 1, wherein said breaking strain falls within a range of 30% to 58%.

3. The superconducting wire according to claim 1, wherein said breaking strain falls within a range of 45% to 58%.

4. The superconducting wire according to claim 1, wherein a proportion of said oxide superconductor falls within a range of 25% to 70%.

5. The superconducting wire according to claim 1, wherein the material of said cladding metal has a maximum stress of at least 180 MPa in the stress-strain test.

6. The superconducting wire according to claim 1, wherein the material of said cladding metal contains silver and/or silver alloy.

7. The superconducting wire according to claim 1, wherein a material of said oxide superconductor contains a bismuth-based oxide superconductor.

8. The superconducting wire according to claim 1, wherein the material of said cladding metal is silver having an impurity concentration of 10 ppm to 500 ppm.

9. A superconducting multifilamentary wire, comprising a plurality of the superconducting wires according to claim 1 and a second cladding metal for cladding said superconducting wires.

10. The superconducting multifilamentary wire according to claim 9, having a tape-like shape.

11. A method of manufacturing a superconducting wire, comprising the steps of:
filling a metal cylinder made of a material of a cladding metal having a breaking strain falling within a range of 30% to 58% in a stress-strain test, with a raw powder containing a raw material of an oxide superconductor (S101); and
subjecting said metal cylinder filled with said raw powder to plastic working at least once and heat treatment at least once (S 103).

12. The method of manufacturing a superconducting wire, according to claim 11, wherein the material of said cladding metal is silver having an impurity concentration of 10 ppm to 500 ppm.

13. A method of manufacturing a superconducting multifilamentary wire, comprising the steps of:
filling a metal cylinder made of a material of a cladding metal having a breaking strain falling within a range of 30% to 58% in a stress-strain test, with a raw powder containing a raw material of an oxide superconductor (S201);
subjecting said metal cylinder filled with said raw powder to plastic working at least once to obtain a wire (S203);
filling a metal cylinder to serve as a material of a second cladding metal, with a plurality of said wires (S205); and
subjecting said metal cylinder filled with said plurality of said wires to plastic working at least once and heat treatment at least once to obtain a superconducting multifilamentary wire (S207).

14. The method of manufacturing a superconducting multifilamentary wire according to claim 13, wherein the material of said cladding metal is silver having an impurity concentration of 10 ppm to 500 ppm.
